# EUROPÄISCHE PATENTSCHRIFT

(11) **EP 1 673 852 B1**
(45) Veröffentlichungstag und Bekanntmachung des Hinweises auf die Patenterteilung: **03.06.2009**
(21) Anmeldenummer: 04786718.9
(22) Anmeldetag: 06.09.2004
(51) Int. Cl.: H02M 1/08, H03K 17/16, H03K 17/10

(54) **VERFAHREN UND SCHALTUNGSANORDNUNG ZUM BETREIBEN EINES DURCH PULSWEITENMODULATION GESTEUERTEN ELEKTROMOTORS**
METHOD AND CIRCUIT ARRANGEMENT FOR OPERATING A PULSE WIDTH MODULATION-CONTROLLED ELECTRIC MOTOR
PROCEDE ET ENSEMBLE CIRCUIT POUR FAIRE FONCTIONNER UN MOTEUR ELECTRIQUE COMMANDE PAR MODULATION D'IMPULSIONS EN LARGEUR

(30) Priorität: 07.10.2003 DE 10346535
(43) Veröffentlichungstag der Anmeldung: 28.06.2006
(73) Patentinhaber: ROBERT BOSCH GMBH, 70442 Stuttgart (DE)
(72) Erfinder: KOCH, Stefan, 77876 Kappelrodeck (DE); HABERL, Nikolas, 77886 Lauf (DE); KOERNER, Michael, 77815 Buehl (DE); FISCHER, Frank, 77815 Buehl Neusatz (DE)
(86) Internationale Anmeldenummer: PCT/DE2004/001996
(87) Internationale Veröffentlichungsnummer: WO 2005/041394

(56) Entgegenhaltungen:
- US-A- 5 929 665
- US-A1- 2002 070 772
- US-B1- 6 320 362

## Beschreibung

### Stand der Technik

Die Erfindung geht aus von einem Verfahren und einer Vorrichtung zum Betreiben eines durch Pulsweitenmodulation gesteuerten Elektromotors an einem Gleichspannungsnetz gemäß der Gattung des Anspruchs 1. Ein derartiges Verfahren ist aus der DE 19944144 A bekannt, wo die Endstufe eines elektronisch kommutierbaren Motors über eine elektronische Steuereinheit mittels pulsweitenmodulierter Signale gesteuert wird. Hierbei wird der Elektromotor mit Spannungsimpulsen aus einem Gleichstromnetz versorgt entsprechend den von einer Sollwertstufe vorgegebenen Steuerspannungsimpulsen. Maßnahmen zur gezielten Formung der Steuerspannungsflanken für die Motorendstufe, beziehungsweise der Flanken des Speisestromes des Motors sind nicht getroffen.

Weiterhin ist es bei handelsüblichen, leistungsstarken Gleichstrommotoren, beispielsweise bei Motoren von Kühlgebläsen für Kraftfahrzeuge, grundsätzlich bekannt, die Spannungsversorgung der Motoren getaktet auszuführen mit einer Motorendstufe in Form eines Feldeffekttransistors. Die Frequenz des Signals der Pulsweitenmodulation liegt aus akustischen Gründen üblicherweise im Bereich zwischen 15 kHz und 100 kHz. Diese Ansteuerung der Motorendstufe ermöglicht eine stufenlose Leistungseinstellung am Motor durch die Taktung der Motorspannung, jedoch mit der negativen Auswirkung einer schlechten elektromagnetischen Verträglichkeit. Um diese zu verbessern ist es weiterhin bekannt, die Schaltflanken des pulsweitenmodulierten Ansteuersignals mit Hilfe einer Kapazität an der Gateelektrode des Feldeffekttransistors zu verschleifen, was jedoch erhebliche Verluste beim Ein- und Ausschalten des Feldeffekttransistors verursacht, welche bei hohen Strömen aufwendig durch zusätzliche Kühlung abgeführt werden müssen.

Aus der US-PS 5 929 665 ist eine Schaltungsanordnung zum Betreiben eines durch Pulsweitenmodulation gesteuerten Elektromotors an einem Gleichspannungsnetz bekannt, welche eine zweistufig arbeitende Treiberstufe, beispielsweise für eine Motorendstufe, besitzt. Der Parallelzweig der Treiberstufe liegt hierbei am gleichen Ausgang der Steuerschaltung wie deren Hauptzweig und wird entsprechend der Höhe des Laststromes aktiviert zur Korrektur des Ansteuersignals der Schalteinrichtung. Als Treiberstufe dient eine mit diskreten Elementen aufgebaute Schaltung oder, bei der Verwendung für einen Leistungsumrichter, eine aus einzelnen Baugruppen bestehende Schaltungsanordnung.

Der Erfindung liegt die Aufgabe zugrunde, ein Verfahren und eine Schaltungsanordnung aufzuzeigen, welche es ermöglichen, bei minimierter Schaltverlusdeistung der Motorendstufe eine möglichst gute elektromagnetische Verträglichkeit zu erreichen. Hierbei soll entweder eine Verringerung der Verlustleistung und damit eine Verringerung des Kühlbedarfs bei unverändert guter elektromagnetischer Verträglichkeit erreicht oder die elektromagnetische Verträglichkeit bei gleicher Verlustleistung deutlich verbessert werden. Vorrangiges Ziel der Erfindung ist die Verbesserung der elektromagnetischen Verträglichkeit bei gleichzeitiger Reduzierung des Aufwandes für die Bauelemente. Dies wird erreicht durch ein Verfahren gemäß Anspruch 1 sowie durch eine Schaltungsanordnung gemäß Anspruch 3, wobei insbesondere eine abrupte Unterbrechung des über den Leistungsschalter fließenden Stroms vermieden wird.

Hierbei ist es zweckmäßig, bei der erfindungsgemäßen Verwendung eines Mikrocontrollers zur Steuerung der Treiberstufe einen zusätzlichen Ausgang des Mikrocontrollers zu nutzen, um zeitversetzt den weiteren Steuerkreis der Treiberstufe zu schalten. Dadurch können die Lade- und/oder Enfladekreise der Eingangskapazität der Motorendstufe zeitunabhängig und getrennt verändert und so die besonders verlustbehafteten Phasen des Stroms über die Endstufe separat beeinflusst werden.

Als vorteilhaft hat es sich erwiesen, als Motorendstufe einen MOSFET-Schalter zu verwenden und dessen Charakteristik zu nutzen, erst ab einem Schwellwert leitfähig zu werden, beziehungsweise den Strom zu unterbrechen. Dieser Schwellwert kann in besonders einfacher Weise genutzt werden als Umschaltbereich der Treiberstufe, um den Strom über die Endstufe langsamer gegen Null zu führen oder den Anstieg des Einschaltstroms für eine kurze Zeitspanne zu begrenzen. Besonders störend wirkt sich jedoch die abfallende Flanke des Stroms über die Endstufe im Bereich des Ausschaltpunktes auf die elektromagnetische Verträglichkeit aus, da diese kurze Phase einem Stromabriss ähnelt und entsprechende Störungen verursacht. Hinsichtlich der Schaltungsanordnung zum Betreiben eines durch Pulsweitenmodulation gesteuerten Elektromotors mit einer wenigstens zweistufig arbeitenden Treiberstufe wird erfindungsgemäß vorgeschlagen, die Treiberstufe über einen Mikrocontroller mit wenigstens zwei Ausgängen für selektiv arbeitende Parallelzweige der Treiberstufe anzusteuern, einerseits für den Betriebsstrom und andererseits für den Stromverlauf im Bereich der Schaltpunkte. Zweckmäßigerweise ist hierzu die Gateelektrode eines als Schalter einer Motorendstufe verwendeten MOSFET über parallele Zweige der Treiberstufe mit verschiedenen Zweigwiderständen mit unterschiedlichen Ausgängen des Mikrocontrollers verbunden. An diesen Ausgängen können zeitlich versetzt Signale bereitgestellt werden, einerseits für den Betriebsstrom und andererseits zur Erzielung eines vorgebbaren Verlaufs der Steuerspannung für die Motorendstufe im Bereich der Einschaltphase und der Ausschaltphase.

Weitere Einzelheiten und vorteilhafte Ausgestaltungen der Erfindung ergeben sich aus der Beschreibung des Ausführungsbeispieles und aus den Unteransprüchen.

Die Abbildungen zeigen in
Fig.1 eine Schaltungsanordnung zum Betreiben eines durch Pulsweitenmodulation gesteuerten Elektromotors und in
Fig.2 den Verlauf der Steuerspannungen der Motorendstufe.

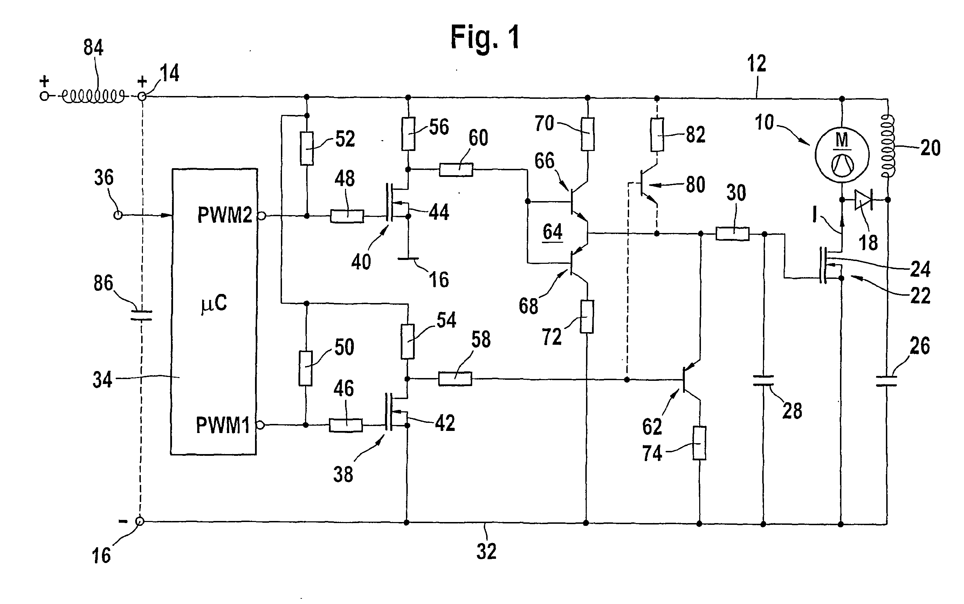

In Fig.1 ist mit 10 ein Gleichstrommotor bezeichnet, welcher als Gebläsemotor für den Lüfter eines Kraftfahrzeuges ausgebildet ist. Der Elektromotor 10 ist über eine Leitung 12 an den Pluspol 14 einer Gleichspannungsquelle angeschlossen, deren Minuspol mit 16 bezeichnet ist. Parallel zum Elektromotor 10 ist ein Freilaufkreis mit einer Diode 18 und einer Induktivität 20 angeordnet, wobei der Verbindungspunkt zwischen der Kathode der Diode 18 und der Induktivität 20 zusätzlich über einen Kondensator 26 mit dem Minuspol 16 der Gleichspannungsquelle verbunden ist.

Zwischen der Gateelektrode des MOSFET-Schalters 24 und dem Minuspols 16 der Gleichspannungsquelle liegt eine Eingangskapazität 28, welche zusammen mit einem Eingangswiderstand 30 und der internen Kapazität des MOSFET-Schalters 24 das Potential an dessen Gateelektrode bestimmt. Die Verbindungsleitung zum Minuspol 16 der Gleichspannungsquelle ist mit 32 bezeichnet.

Die Steuerung des Elektromotors 10 erfolgt durch einen Mikrocontroller 34, welcher an seinem Eingang 36 neben der Versorgungsspannung von 5 V ein Signal für die Pulsweitenmodulation der Steuerimpulse sowie ein Signal für den Arbeitspunkt des Motorstroms erhält. Zwei Impulsausgänge PWM1 und PWM2 des Mikrocomputers 34 sind über parallele Zweige einer Treiberstufe mit der Gateelektrode des MOSFET-Schalters 24 verbunden. Die Treiberstufe weist zwei Inverterstufen 38 und 40 auf mit zwei MOSFETs 42 und 44, welche mit ihren Gateelektroden über Widerstände 46 und 48 mit den Impulsausgängen PWM1 und PWM2 des Mikrocontrollers 34 sowie von dort über Widerstände 50 und 52 mit dem Pluspol 14 der Gleichspannungsquelle verbunden sind. Die Drainelektroden der MOSFETs 42 und 44 liegen einerseits über Widerstände 54 und 56 am Pluspo 1 14 der Gleichspannungsquelle sowie über Widerstände 58 und 60 an den Steuerelektroden einerseits eines Entladetransistors 62 für die Eingangskapazität 28 und andererseits an einer in bekannter Weise arbeitenden Gegentaktstufe 64 mit zwei Transistoren 66 und 68 für die Steuerung der Motorendstufe 22. Die Sourceelektroden der MOSFETs 42 und 44 sind an den Minuspol 16 der Gleichspannungsquelle angeschlossen. Der Kollektor des Transistors 66 ist über einen Widerstand 70 mit dem Pluspol 14 und der Kollektor des Transistors 68 über einen Widerstand 72 mit dem Minuspol 16 der Gleichspannungsquelle verbunden. Die Emitter der Transistoren 62, 66 und 68 sind an den Eingangswiderstand 30 angeschlossen, der Kollektor des Transistors 62 liegt über einem Widerstand 74 ebenfalls am Minuspol 16 der Gleichspannungsquelle.

Mit gestrichelten Linien sind in Fig. 1 zusätzliche optionale Schaltelemente dargestellt. Hierbei handelt es sich um eine Induktivität 84 und eine Kapazität 86 am Eingang der Schaltungsanordnung, welche zu Entstörzwecken in der Regel vorgesehen werden. Beim Anmeldungsgegenstand können diese Bauelemente zumindest deutlich verkleinert werden. Weiterhin sind mit gestrichelten Linien ein Transistor 80 und ein Ladewiderstand 82 zwischen der Leitung 12 zum Pluspol 14 der Batterie und dem Eingangswiderstand 30 dargestellt. Die Basis des Transistors 80 kann über die Inverterstufe 38 und den Impulsausgang PWM1 des Mikrocontrollers 34 angesteuert werden, um alternativ oder zusätzlich zur Beeinflussung der fallenden Flanke des Steuerimpulses für die Endstufe 22 auch den Verlauf der ansteigenden Flanke des Steuerimpulses am Gate der Endstufe zu verändern.

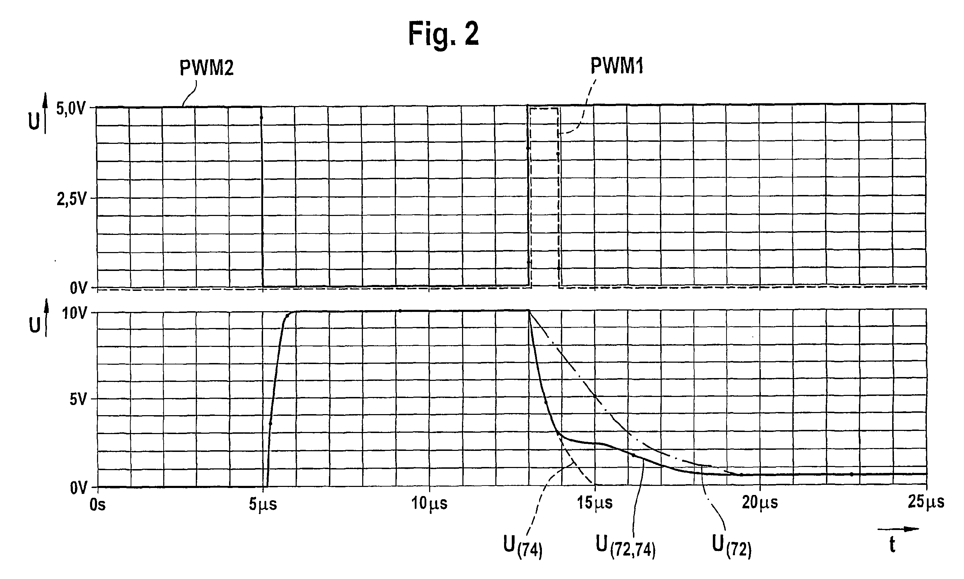

In Fig. 2 ist im oberen Diagramm mit einer durchgezogenen Linie der Verlauf der Steuerspannung am Ausgang PWM2 und mit einer gestrichelten Linie der Verlauf der Steuerspannung am Ausgang PWM1 des Mikrocontrollers 34 dargestellt. Das untere Diagramm in Fig. 2 zeigt mit einer durchgezogenen Linie den Verlauf der Steuerspannung der Motorendstufe 22 bei Entladung der Eingangskapazität 28 an der Gateelektrode des MOSFET-Schalters 24 einschließlich dessen interner Kapazität zunächst über den niederohmigen Widerstand 30 mit ca. 5 bis 10 Ohm und über die Parallelschaltung der Widerstände 72 und 74 und anschließend allein über den höherohmigen Widerstand 72. Mit einer gestrichelten Linie ist der Verlauf der Steuerspannung ohne die Steuerungsmaßnahmen vom Ausgang PWM1 des Mikrocontrollers 34 dargestellt, wobei sich die Eingangskapazität 28 des MOSFET-Schalters 24 über den Widerstand 74 schnell entlädt. Die strichpunktierte Linie zeigt den Verlauf der Gatespannung am MOSFET-Schalter 24 bei verzögerter Entladung der Eingangskapazität 28 über den höherohmigen Widerstand 72, wodurch unter Inkaufnahme beträchtlicher Verluste an der Endstufe in bekannter Weise die elektromagnetische Verträglichkeit der Schaltungsanordnung verbessert werden kann. Der Verlauf der Gatespannung des MOSFET-Schalters 24 entspricht dabei oberhalb einer Schwelle von 2 bis 4 Volt, im Ausführungsbeispiel oberhalb einer Schwelle von circa 2,5 Volt, im Wesentlichen dem Verlauf des Stromes I über den MOSFET-Schalter 24.

Die erfindungsgemäße Schaltungsanordnung arbeitet folgendermaßen:

Der Elektromotor 10, im Ausführungsbeispiel der mit einem Gebläse gekoppelte Gleichstrommotor eines Kraftfahrzeuges, ist über die Leitung 12 mit dem Pluspol 14 sowie über die als MOSFET-Schalter 24 ausgebildete Motorendstufe 22 und die Leitung 32 mit dem Minuspol 16 des Gleichspannungsnetzes verbunden. Parallel zum Motor ist ein Freilaufkreis mit einer Diode 18 und einer Induktivität 20 geschaltet, welcher in den Stromflusspausen des MOSFET-Schalters 24 den Motorstrom in nahezu unveränderter Höhe übernimmt. Parallel zum MOSFET-Schalter 24 und zur Diode 18 liegt weiterhin ein Glättungskondensator 26.

Die Steuerung des MOSFET-Schalters 24 erfolgt über den Mikrocontroller 34. Die Höhe des Motorstromes wird im Wesentlichen bestimmt von einem pulsweitenmodulierten Signal am Ausgang PWM2 des Mikrocontrollers 34. Solange an diesem Ausgang ein High-Signal anliegt ist der MOSFET 44 leitend. An seiner Drainelektrode liegt nahezu Massepotential, wodurch der Transistor 66 der Gegentaktstufe 64 gesperrt ist und kein Ladestrom über den Eingangswiderstand 30 zur Eingangskapazität 28 des MOSFET-Schalters 24 fließt. Die Motorendstufe 22 ist somit nichtleitend, der Motorstromkreis schließt sich über die Diode 18 und die Induktivität 20.

Sobald das Ausgangssignal PWM2 des Mikrocontrollers 34 von High nach Low wechselt, wird der MOSFET 44 nichtleitend, da seine Gateelektrode die Durchbruchsspannung nicht erreicht. An der Drainelektrode des MOSFET 44 liegt nun nahezu positives Potential an, wodurch der Transistor 66 der Gegentaktstufe 64 leitend wird und über den niederohmigen Eingangswiderstand 30 die Eingangskapazität 28 sehr schnell auflädt. Hierdurch steigt auch die Gatespannung des MOSFET-Schalters 24 sehr schnell an und ab einer Schwelle von cirka 2,5 Volt auch der Strom I am Ausgang der Motorendstufe. Der Strom I fließt dann in konstanter Höhe so lange über den MOSFET-Schalter 24, bis am Ausgang PWM2 des Mikrocontrollers 34 wieder ein High-Signal anliegt, der MOSFET 44 leitend wird und der Transistor 66 den Ladevorgang für die Eingangskapazität 28 unterbricht. Mit dem Anliegen von Massepotential am Steuereingang der Gegentaktstufe 64 wird der Transistors 68 leitend und damit die Eingangskapazität 28 über den Widerstand 72 entladen. Die Geschwindigkeit der Entladung der Eingangskapazität 28 bestimmt den Spannungsverlauf an der Gateelektrode des MOSFET-Schalters 24 und somit den Verlauf des Stromes I über den MOSFET-Schalter, welcher unterhalb des Schwellwertes von cirka 2,5 Volt an der Gateelektrode auf Null abfällt.

An den Verlauf des Stromes I über die Motorendstufe 22 werden nun unterschiedliche Forderungen gestellt. Einerseits wird ein sehr schneller Anstieg und ein sehr schneller Abfall des Stromes I gefordert, um die Schaltverluste im MOSFET-Schalter 24 so gering wie möglich zu halten, da diese Verluste die im MOSFET entstehende Wärme verursachen, welche aufwendig durch Kühlung abgeführt werden muss. Andererseits verursacht insbesondere ein schneller Abfall des Stromes über die Endstufe 22 gegen Null, was einem Stromabriss nahe kommt, eine erhebliche Verschlechterung der elektromagnetischen Verträglichkeit der Anordnung. Dies gilt insbesondere bei der Taktung von hohen Strömen, beispielsweise bei Gebläsemotoren in Kraftfahrzeugen in der Größenordnung von ca. 20 bis 50 A, sowie hinsichtlich der Frequenz der üblicherweise verwendeten pulsweitenmodulierten Signale, welche aus akustischen Gründen zwischen 15 kHz und 100 kHz liegen. Der langsame Anstieg und Abfall des Ausgangsstromes I der Motorendstufe 22 könnte nun zwar durch einen verlangsamten Lade- und Entladevorgang der Eingangskapazität 28 erreicht werden, jedoch zu Lasten erheblicher Verluste im MOSFET-Schalter 24.

Erfindungsgemäß kann die elektromagnetische Verträglichkeit der Schaltungsanordnung nun dadurch erreicht werden, dass die Treiberstufe für die Motorendstufe 22 zweistufig ausgebildet wird mit zusätzlichen Steuermitteln zur selektiven Beeinflussung des Verlaufs der Flanken der Ausgangsstromimpulse der Motorendstufe 22. Hierdurch kann bei minimierter Schaltverlustleistung des MOSFETs 24 eine zufrieden stellende elektromagnetische Verträglichkeit und eine Reduzierung des Bauelementeaufwandes erreicht werden oder es ist möglich, ohne Erhöhung der Verlustleistung eine deutliche Verbesserung der elektromagnetischen Verträglichkeit zu erzielen. Hinsichtlich der elektromagnetischen Verträglichkeit muss insbesondere der Verlauf der abfallenden Flanke des Stroms der Motorendstufe 22 beeinflusst werden, und zwar derart, dass der Strom I zunächst sehr schnell abnimmt um die Verlustleistung klein zu halten, dass aber danach der Verlauf der abfallenden Flanke deutlich abgeflacht wird, um einen abrupten Übergang des Stromes I zum Nullpunkt hin zu vermeiden. Dies erreicht man durch die zweistufige Ausbildung der Treiberstufe für die Motorendstufe.

Bei der Verwendung eines MOSFET-Schalters 24 als Motorendstufe 22 kann zur Beeinflussung des Flankenverlaufs des Stromes I die nichtlineare Eigenschaft des Feldeffekttransistors genutzt werden, welcher erst oberhalb eines Schwellwertes der Steuer spannung von cirka 2,5 Volt leitfähig wird, beziehungsweise erst unterhalb dieses Spannungswertes sperrt. Die elektromagnetische Verträglichkeit kann also bei gleichzeitiger Verringerung der Verlustleistung der Motorendstufe 22 bei Verwendung eines MOSFT-Schalters in besonders einfacher Weise dadurch deutlich verbessert werden, dass der Abfall der Steuerspannung des MOSFET-Schalters 24 und damit auch der Abfall des Stromes I zunächst beschleunigt und danach im Ausschaltbereich verlangsamt werden. Hierdurch wird bei reduzierter Verlustleistung der abrupte Stromabriss vermieden und die elektromagnetische Verträglichkeit verbessert. Dies erreicht man bei der Schaltungsanordnung gemäß Fig. 1 durch einen zusätzlichen Entladekreis für die Eingangskapazität des MOSFET-Schalters 24 mit einer gegenüber dem Entladekreis über den Transistor 68 und den Widerstand 72 deutlich verringerten zeitkonstanten auf Grund eines geringeren Widerstandswertes des Widerstandes 74 gegenüber dem Widerstand 72. Der Transistor 62 ist dabei parallel zu dem Transistor 68 so lange leitend, wie an seiner Basis Massepotential anliegt. Dies ist der Fall, solange der MOSFET 42 leitend ist, dass heißt, solange an der Gateelektrode des MOSFETs 42 ein High-Signal des Ausgangs PWM1 des Mikrocontrollers 34 anliegt. Sobald dieses endet verlangsamt sich der Abfallder Steuerspannung am Gate des MOSFET-Schalters 24 und damit der Abfall des Stromverlaufs zum Ende des Abschaltvorganges hin.

Zur Eingangskapazität des MOSFET-Schalters 24 zählt neben der externen Eingangskapazität 28 auch die Gatekapazität des Feldeffekttransistors 24 selbst. Das Verhältnis der Widerstandwerte der Widerstände 74 und 72 liegt vorzugsweise im Bereich von 1:3 bis 1:5. Einem Widerstandswert von zum Beispiel 30 Ω für den Widerstand 74 entspricht dann ein Widerstandswert von 90 bis 150 Ω für den Widerstand 72.

Die Maßnahmen zur Beeinflussung der ansteigenden Flanke der Steuerspannung für die Motorendstufe 22 sind in Fig. 1 gestrichelt angedeutet. Hierzu kann ein zusätzlicher Ladekreis für die Eingangskapazität 28 über einen Transistor 80 und einen Widerstand 82 bereitgestellt werden. Der Widerstandswert des Widerstandes 82 ist deutlich höher als derjenige des Widerstandes 70 im Ladekreis über den Transistor 66 der Gegentaktstufe 64. In diesem Fall wird über den Ausgang PWM1 des Mikrocontrollers 34 vor dem Umschalten seines Ausganges PWM2 von High auf Low ein Low-Signal ausgegeben, welches den MOSFET 42 sperrt und den Transistor 80 für kurze Zeit leitfähig macht, so dass vor dem Einschalten des Transistors 66 der Transistor 80 über den höherohmigen Widerstand 82 einen reduzierten Ladestrom an die Eingangskapazität 28 liefert und den MOSFET-Schalter 24 mit verringertem Anstieg der Steuerspannung in den leitfähigen Zustand versetzt. Die Anordnung mit dem Transistor 80 und dem Widerstand 82 ist gestrichelt als Alternative zur Einschaltung des Transistors 62 und des Widertandes 74 dargestellt. Sollen beide Flanken des Stromes I über die Motorendstufe 22 in ihrem Verlauf beeinflusst werden, so müssen die Schaltkreise über die Transistoren 62 und 80 beide vorhanden sein und getrennt ausgeführt und angesteuert werden.

Schließlich sind in Fig. 1 mit gestrichelten Linien noch eine Induktivität 84 und ein Kondensator 86 am Eingang der Schaltung dargestellt, wie sie üblicherweise zur Verbesserung der elektromagnetischen Verträglichkeit verwendet werden. Hierbei handelt es sich im Normalfall um eine Induktivität von einigen µH und einen Folienkondensator von einigen µF, welche in Verbindung mit der erfindungsgemäßen Schaltung wahlweise zur weiteren Verbesserung der elektromagnetischen Verträglichkeit zusätzlich angeordnet, ansonsten aber zumindest verringert oder ganz weggelassen werden können.

In Fig. 2 ist im oberen Diagramm der Verlauf der Ausgangssignale PWM1 und PWM2 an den Ausgängen des Mikrocontrollers 34 dargestellt für den Fall der Einflussnahme auf die abfallende Flanke des Stromes durch die Motorendstufe 22. Hierbei ist der Signalverlauf PWM1 gestrichelt und der Signalverlauf PWM2 mit einer durchgehenden Linie gezeichnet.

Die ansteigende Flanke der Gatespannung des MOSFET-Schalter 24 gemäß dem unteren Diagramm in Fig. 2 wird bei diesem Signalverlauf ausschließlich durch den Wechsel des Signals PWM2 von High auf Low bestimmt, wobei der Ladestrom für die Eingangskapazität 28 über den Widerstand 70 hoch ist und der MOSFET-Schalter 24 mit einem sehr steilen Anstieg der Steuerspannung in den leitfähigen Zustand wechselt. Der MOSFET-Schalter 24 bleibt dann leitend, solange das Ausgangssignal PWM2 auf Low verharrt.

Gleichzeitig mit dem erneuten Auftreten des Ausgangssignals PWM2 erscheint am anderen Ausgang des Mikrocontrollers 34 das Ausgangssignal PWM1, welches den Transistor 62 in den leitenden Zustand versetzt, sodass die Eingangskapazität 28 über die Parallelschaltung des Widerstandes 72 und des niederohmigen Widerstandes 74 sehr schnell entladen wird. Der Strom I über den MOSFET-Schalter 24 nimmt rasch ab, sobald dessen Gatespannung unter den Schwellwert von 2,5 Volt abgesunken ist. Das Ausgangssignal PWM1 liegt im gezeigten Ausführungsbeispiel für die Dauer von 400 ns ab einem Zeitpunkt von 13 µs an. Danach wechselt das Ausgangssignal PWM1 von High auf Low, der Transistor 62 wird nichtleitend und die weitere Entladung der Eingangskapazität 28 erfolgt nun langsamer entsprechend der durchgezogenen Linie im unteren Diagramm der Fig. 2 über den Widerstand 72 mit entsprechend größerer Zeitkonstante.

Zum Vergleich ist im unteren Diagramm der Fig. 2 schematisch mit einer gestrichelten Linie, beziehungsweise mit einer strichpunktierten Linie der Verlauf der Gatespannung dargestellt, wie sie sich bei einstufiger Ausbildung der Treiberstufe einerseits bei kleiner Zeitkonstante und geringen Verlusten und andererseits bei großer Zeitkonstante und guter elektromagnetischer Verträglichkeit ergeben. Mit der Gatespannung U(74) könnte dabei die Verlustleistung zwar gering gehalten werden, die elektromagnetische Verträglichkeit wäre jedoch aufgrund der schnellen Änderung des Stromverlaufs über der Motorendstufe 22 deutlich schlechter. Andererseits wäre bei guter elektromagnetischer Verträglichkeit entsprechend dem Gatespannungsverlauf U(72) die Verlustleistung und die Erwärmung in der Motorendstufe 22 unakzeptabel hoch. Mit dem erfindungsgemäßen Verfahren und der zugehörigen Schaltungsanordnung erreicht man bei einem Gatespannungsverlauf U(72,74) entsprechend der durchgezogenen Linie über die Motorendstufe 22 ein kontrolliertes Schaltverhalten mit einer positiven Beeinflussung des Abstrahlverhaltens.

## Patentansprüche

1. Verfahren zum Betreiben eines durch Pulsweitenmodulation gesteuerten Elektromotors (10) an einem Gleichspannungsnetz (14,16), insbesondere zum Betreiben eines Gebläsemotors am Bordnetz eines Kraftfahrzeuges, mit einer wenigstens zweistufig arbeitenden Treiberstufe für eine vorzugsweise auf der Masseseite des Motors (10) angeordnete Motorendstufe (22), **dadurch gekennzeichnet, dass** die Treiberstufe von einem Mikrocontroller (34) gesteuert wird und über einen zusätzlichen Ausgang des Mikrocontrollers (34) Steuerimpulse (PWM1) erhält zur selektiven Veränderung der Zeitkonstanten des Lade- und/oder Entladekreises der Eingangskapazität (28) der Motorendstufe (22) am Beginn und/oder am Ende eines Ausgangsstromimpulses (PWM2).

2. Verfahren nach Anspruch 1, **dadurch gekennzeichnet, dass** der Spannungsverlauf an der Gateelektrode eines MOSFET-Schalters (24) der Motorendstufe (22) über wenigstens zwei getrennte Ausgänge (PWM1, PWM2) des Mikrocontrollers (34) mittels zeitlich versetzter Signale gesteuert wird.

3. Schaltungsanordnung zum Betreiben eines durch Pulsweitenmodulation gesteuerten Elektromotors (10) an einem Gleichspannungsnetz (14,16), insbesondere zum Betreiben eines Gebläsemotors am Bordnetz eines Kraftfahrzeuges, mit einer wenigstens zweistufig arbeitenden Treiberstufe für eine vorzugsweise auf der Masseseite des Motors (10) angeordnete Motorendstufe (22), **dadurch gekennzeichnet, dass** die Treiberstufe durch einen Mikrocontroller gesteuert ist, wobei die Gateelektrode eines MOSFET-Schalters (24) der Motorendstufe (22) über einen Parallelzweig (42,62,80) der Treiberstufe selektiv am Beginn und/oder am Ende eines Ausgangsstromimpulses (PWM2) mit einem zusätzlichen Ausgang (PWM1) des Mikrocontrollers (34) verbunden ist.

4. Schaltungsanordnung nach Anspruch 3, **dadurch gekennzeichnet, dass** parallele Zweige (38,40;62,64,80) der Treiberstufe mit unterschiedlichen Zweigwiderständen (70,72,74,82) an unterschiedliche Ausgänge (PWM1, PWM2) des Mikrocontrollers (34) angeschlossen sind.

5. Schaltungsanordnung nach Anspruch 4, **dadurch gekennzeichnet, dass** die parallelen Zweige der Treiberstufe für die Motorendstufe (22) jeweils über eine Inverterstufe (42,44) mit den Ausgängen (PWM1, PWM2) des Mikrocontrollers (34) verbunden sind.

## Claims

1. Method for operating a pulse width modulation-controlled electric motor (10) from a DC voltage system (14, 16), in particular for operating a blower motor from the on-board electrical system of a motor vehicle, with a driver stage, which operates in at least two stages, for a motor output stage (22) which is preferably arranged on the earth side of the motor (10), **characterized in that** the driver stage is controlled by a microcontroller (34) and receives control pulses (PWM1) via an additional output of the microcontroller (34) for selectively changing the time constant of the charging and/or discharging circuit of the input capacitance (28) of the motor output stage (22) at the start and/or end of an output current pulse (PWM2).

2. Method according to Claim 1, **characterized in that** the voltage profile at the gate electrode of a MOSFET switch (24) of the motor output stage (22) is controlled, via at least two separate outputs (PWM1, PWM2) of the microcontroller (34), by means of temporally offset signals.

3. Circuit arrangement for operating a pulse width modulation-controlled electric motor (10) from a DC voltage system (14, 16), in particular for operating a blower motor from the on-board electrical system of a motor vehicle, with a driver stage, which operates in at least two stages, for a motor output stage (22) which is preferably arranged on the earth side of the motor (10), **characterized in that** the driver stage is controlled by a microcontroller, the gate electrode of a MOSFET switch (24) of the motor output stage (22) being selectively connected to an additional output (PWM1) of the microcontroller (34) at the start and/or end of an output current pulse (PWM2) via a parallel branch (42, 62, 80) of the driver stage.

4. Circuit arrangement according to Claim 3, **characterized in that** parallel branches (38, 40; 62, 64, 80) of the driver stage having different branch resistors (70, 72, 74, 82) are connected to different outputs (PWM1, PWM2) of the microcontroller (34).

5. Circuit arrangement according to Claim 4, **characterized in that** the parallel branches of the driver stage for the motor output stage (22) are each connected to the outputs (PWM1, PWM2) of the microcontroller (34) via an inverter stage (42, 44).

## Revendications

1. Procédé de gestion d'un moteur électrique (10) commandé par modulation de la largeur d'impulsions sur un réseau (14, 16) à tension continue, et en particulier de gestion du moteur d'un ventilateur sur le réseau de bord d'un véhicule automobile, qui présente un étage pilote qui travaille au moins en deux étages pour un étage final (22) du moteur disposé de préférence sur le côté de la masse du moteur (10),
**caractérisé en ce que**
l'étage pilote est commandé par un microcontrôleur (34) et reçoit par une entrée supplémentaire du microcontrôleur (34) des impulsions de commande (PWM1) qui modifient de manière sélective la constante de temps du circuit de charge et/ou de décharge de la capacité d'entrée (28) de l'étage final (22) du moteur au début et/ou à la fin d'une impulsion (PWM2) de courant de sortie.

2. Procédé selon la revendication 1, **caractérisé en ce que** l'évolution de la tension appliquée sur l'électrode de grille d'un commutateur (24) à MOSFET de l'étage final (22) du moteur est commandée par au moins deux sorties séparées (PWM1, PWM2) du microcontrôleur (34) au moyen de signaux décalés dans le temps.

3. Circuit de gestion d'un moteur électrique (10) commandé par modulation de la largeur d'impulsions sur un réseau (14, 16) à tension continue, et en particulier de gestion du moteur d'un ventilateur sur le réseau de bord d'un véhicule automobile, avec un étage pilote qui travaille en au moins deux étages pour un étage final (22) du moteur disposé de préférence sur le côté de la masse du moteur (10),
**caractérisé en ce que**
l'étage pilote est commandé par un microcontrôleur, l'électrode de grille d'un commutateur (24) à MOSFET de l'étage final (22) du moteur étant reliée sélectivement par une branche parallèle (42, 62, 80) de l'étage pilote au début et/ou à la fin d'une impulsion (PWM2) de courant de sortie à une sortie supplémentaire (PWM1) du microcontrôleur (34).

4. Circuit selon la revendication 3, **caractérisé en ce que** des branches parallèles (38, 40 ; 62, 64, 80) de l'étage pilote sont raccordées par l'intermédiaire de résistances différentes (70, 72, 74, 82) à différentes sorties (PWM1, PWM2) du microcontrôleur (34).

5. Circuit selon la revendication 4, **caractérisé en ce que** chacune des branches parallèles de l'étage pilote de l'étage final (22) du moteur est reliée par un étage d'inversion (42, 44) respectif à une sortie (PWM1, PWM2) du microcontrôleur (34).
